# FASCICULE DE BREVET EUROPEEN

(11) **EP 2 471 103 B1**
(45) Date de publication et mention de la délivrance du brevet: **02.01.2019**
(21) Numéro de dépôt: 10762743.2
(22) Date de dépôt: 23.08.2010
(51) Int. Cl.: H01L 31/0236

(54) **PROCÉDÉ DE TEXTURATION DE LA SURFACE D'UN SUBSTRAT DE SILICIUM ET SUBSTRAT DE SILICIUM TEXTURÉ POUR CELLULE SOLAIRE**
VERFAHREN ZUR TEXTURIERUNG EINES SILIZIUMSUBSTRATES UND TEXTURIERTES SILIZIUMSUBSTRAT FÜR SOLARZELLE
METHOD FOR TEXTURING THE SURFACE OF A SILICON SUBSTRATE, AND TEXTURED SILICON SUBSTRATE FOR A SOLAR CELL

(30) Priorité: 24.08.2009 FR 0955767
(43) Date de publication de la demande: 04.07.2012
(73) Titulaire: Total S.A., 92400 Courbevoie (FR); Centre National de la Recherche Scientifique, 75794 Paris Cedex 16 (FR); Ecole Polytechnique, 91128 Palaiseau Cedex (FR)
(72) Inventeur: ROCA I CABARROCAS, Pere, 91140 Villebon Sur Yvette (FR); MORENO, Mario, 91120 Palaiseau (FR); DAINEKA, Dimitri, 91120 Palaiseau (FR)
(74) Mandataire: Jacobacci Coralis Harle
(86) Numéro de dépôt international: PCT/FR2010/051756
(87) Numéro de publication internationale: WO 2011/023894

(56) Documents cités:
- LEE W J ET AL: "High-density hollow cathode plasma etching for large area multicrystalline silicon solar cells", CONFERENCE RECORD OF THE 29TH IEEE PHOTOVOLTAIC SPECIALISTS CONFERENCE 20020519; 20020519 - 20020524 NEW YORK, NY : IEEE, US LNKD- DOI:10.1109/PVSC.2002.1190517, vol. CONF. 29, 19 mai 2002 (2002-05-19), pages 296-299, XP010666287, ISBN: 978-0-7803-7471-3
- YOO J ET AL: "RIE texturing optimization for thin c-Si solar cells in SF6/O2 plasma", JOURNAL OF PHYSICS D. APPLIED PHYSICS, IOP PUBLISHING, BRISTOL, GB, vol. 41, no. 12, 21 juin 2008 (2008-06-21) , page 125205, XP020133363, ISSN: 0022-3727 cité dans la demande
- YOO J ET AL: "Black surface structures for crystalline silicon solar cells", MATERIALS SCIENCE AND ENGINEERING B, ELSEVIER SEQUOIA, LAUSANNE, CH LNKD- DOI:10.1016/J.MSEB.2008.10.019, vol. 159-160, 15 mars 2009 (2009-03-15), pages 333-337, XP026109149, ISSN: 0921-5107 [extrait le 2009-03-15]

## Description

L'invention concerne un procédé de texturation de la surface d'un substrat de silicium en phase gazeuse et un substrat de silicium texturé pour cellule solaire obtenu avec ce procédé.

Un tel substrat de silicium texturé est ensuite utilisé pour la fabrication d'hétérojonctions de cellules solaires.

La texturation des substrats de silicium cristallin c-Si (100) est largement utilisée pour la fabrication de cellules solaires en silicium à haut rendement.

La texturation de la surface des substrats de silicium cristallin permet de réduire la réflectivité lumineuse de leur surface, d'augmenter le piégeage de la lumière, d'augmenter le courant produit, et donc l'efficacité dans les cellules solaires.

Les procédés de texturation consistent à former des structures en forme de pyramide sur la surface du substrat. Ces pyramides peuvent être inversées ou non inversées.

On connaît du document « Martin A Green, Jianhua Zhao, Aihua Wang and Stuart R Wenham, IEE Transactions on Electronic Devices, Vol. 46, No. 10, pp. 1940 - 1947 (1999) » un procédé de photolithographie et de gravure par voie humide permettant d'obtenir un substrat de silicium c-Si (100) avec des structures en forme de pyramides inversées sur sa surface.

Cette méthode permet d'obtenir des basses réflectivités de l'ordre de 8% et un rendement de 24,7 %.

Néanmoins, ce procédé est long, onéreux, et polluant car il nécessite l'utilisation de grandes quantités d'eau déionisée, et de solutions chimiques telles que des solutions de KOH ou de NaOH, qu'il faut recycler.

De plus, la texturation n'est pas seulement réalisée sur une seule face du substrat mais également sur sa face arrière, entraînant une diminution de la qualité de la passivation de cette dernière.

Pour résoudre ces problèmes, on connaît du document « J Yoo, Kyunghae Kim, M. Thamilselvan, N. Lakshminarayan, Young Kuk Kim, Jaehyeong Lee, Kwon Jong Yoo and Junsin Yi, "RIE texturing optimization for thin c-Si solar cells in SF6/O2 plasma", Journal of Physics D: Applied Physics, vol 41, 125205, pp. 1 - 7 (2008) », une méthode de gravure par voie sèche utilisant un plasma de SF₆/O₂ pour texturer la surface d'un substrat de silicium cristallin c-Si (100). Ce procédé est réalisé dans un appareil de gravure ionique réactive (RIE « Reactive Ion Etching ») apte à générer un plasma radiofréquence en présence de gaz.

Un substrat de silicium texturé a été obtenu en utilisant une pression de SF₆/O₂ de 265 mTorr, et en appliquant un plasma radiofréquence pendant 5 à 20 min avec une puissance RF de 100 W.

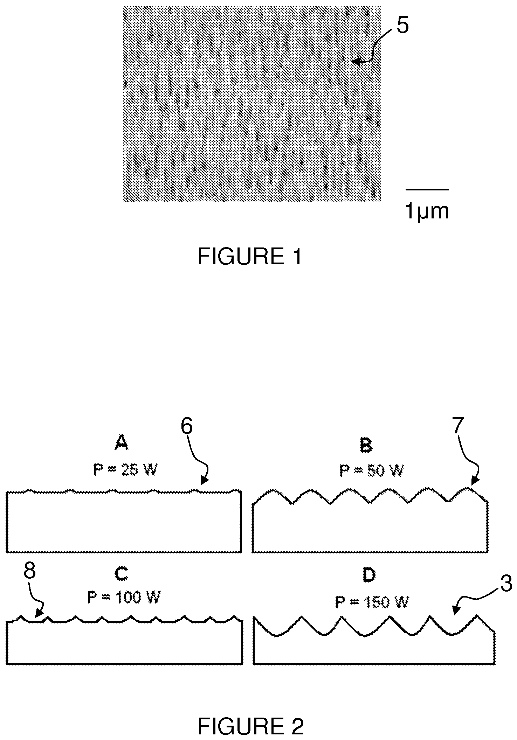

On obtient par ce procédé de texturation une multitude de structures en forme d'aiguille 5 à la surface du substrat de silicium, comme illustré sur la figure 1. Les réflectivités et rendements obtenus sont comparables à ceux obtenus avec les procédés par voie humide.

Néanmoins, une telle surface présentant des pics ou aiguilles, rend le substrat texturé inutilisable pour la fabrication de cellules solaires. En effet, il est ensuite difficile, voir impossible de déposer une autre couche de silicium de façon homogène.

Ainsi, l'invention a pour objet de fournir un procédé de texturation en phase gazeuse permettant d'obtenir un substrat de silicium ayant une très bonne réflectivité (inférieure à 6%), avec une surface texturée sans structures en forme d'aiguilles, utilisable pour la fabrication de cellules solaires.

A cet effet, l'invention concerne un procédé de texturation en phase gazeuse de la surface d'un substrat de silicium tel que défini dans la revendication 1. Ce procédé comprend l'étape suivante :
a) exposition de ladite surface à un plasma radiofréquence de SF₆/O₂ dans une chambre de réaction pendant une durée comprise entre 2 min et 30 min, pour produire un substrat de silicium ayant une surface texturée présentant des structures pyramidales, le rapport SF₆/O₂ étant compris entre 2 et 10.
Et selon l'invention :
- le procédé de texturation de la surface du substrat de silicium comprend, avant l'étape a), une étape a') d'exposition de ladite surface à un plasma radiofréquence d'oxygène pendant une durée allant jusqu'à 8 minutes.
- lors de l'étape a), la densité de puissance générée avec le plasma radiofréquence est supérieure ou égale à 3000 mW/cm², et la pression de SF₆/O₂ dans la chambre de réaction est inférieure ou égale à 100 mTorr, de façon à produire un substrat de silicium ayant une surface texturée présentant des structures pyramidales de type inversé.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- lors de l'étape a'), la densité de puissance générée avec le plasma radiofréquence est comprise entre 500 mW/cm² et 4000 mW/cm², la pression d'oxygène dans la chambre de réaction étant comprise entre 50 mTorr et 150 mTorr,
- lors des étapes a) et a'), la densité de puissance générée avec le plasma radiofréquence est égale à 3000 mW/cm²,
- lors de l'étape a), la pression de SF₆/O₂ dans la chambre de réaction est de 100 mTorr, le rapport SF₆/O₂ est de 3 et la durée d'exposition au plasma est de 15 min,
- pendant les étapes a) et/ou a'), la puissance du plasma radiofréquence est augmentée progressivement,
- la durée de l'étape a') est de 5 min,
- les étapes a) et a') sont réalisées dans un appareil de gravure ionique réactive.

L'invention concerne également un substrat de silicium texturé pour cellule solaire présentant une surface texturée avec des structures pyramidales du type inversé et une résistivité comprise entre 0,5 Ω.cm et 30 Ω.cm.

Selon l'invention, les structures pyramidales inversées présentent une largeur comprise entre 200 nm et 3 µm, et une profondeur comprise entre 200 nm et 1 µm.

Dans différents modes de réalisation possibles, la présente invention concerne également la caractéristique suivante qui apporte des avantages spécifiques :
- la surface texturée du substrat de silicium présente des structures en forme de pyramide inversée de grandes tailles, et des structures en forme de pyramide inversée de petites tailles, la largeur des structures en forme de pyramide inversée de grandes tailles étant comprise entre 1 µm et 3 µm, et la largeur des structures en forme de pyramide inversée de petites tailles étant comprise entre 200 nm et 1 µm.

Ainsi, l'invention fournit un procédé de texturation en phase gazeuse permettant d'obtenir un substrat de silicium ayant une très bonne réflectivité (inférieure à 6%), avec une surface texturée sans structures en forme d'aiguilles, utilisable pour la fabrication de cellules solaires ou de capteurs optiques.

La rugosité de surface est compatible avec le dépôt de couches minces de silicium dopées pour la formation de la jonction ou hétérojonction.

Localement, la rugosité de la surface texturée est plus faible que celle de l'art antérieur.

Il est possible de réaliser un dépôt de silicium homogène sur une telle surface texturée. Le dépôt peut être une couche homogène de a-Si :H intrinsèque ou dope (type p ou n) pour former une hétérojonction ou d'une couche de silicium épitaxie pour former une homojonction.

Ce procédé de texturation simple permet de réduire les étapes du processus de fabrication, et donc de réduire les temps et coûts de fabrication des cellules solaires, et l'impact sur l'environnement. Il permet également d'utiliser moins de matière.

Le procédé est facilement intégrable dans une ligne de production.

La réflectivité obtenue avec le procédé de l'invention est inférieure à celle obtenue avec les techniques connues par voie humide.

La réflectivité est faible dans la gamme de fonctionnement des cellules solaires (400 nm à 1000 nm).

L'invention sera décrite plus en détail en référence aux dessins annexés dans lesquels :
- la figure 1 représente un substrat de silicium texturé obtenu avec un procédé de texturation de l'art antérieur ;
- la figure 2 représente schématiquement quatre coupes de substrat de silicium texturé obtenu avec des puissances RF différentes, selon plusieurs modes de réalisation de l'invention ;
- la figure 3 représente des photographies de substrats de silicium texturé obtenues avec un microscope électronique à balayage, pour des puissances RF différentes et des rapports SF₆/O₂ différents ;
- la figure 4 représente des images et des profiles de la surface des échantillons de silicium texturé réalisées par AFM ;
- la figure 5 représente des courbes de réflectivité pour des substrats de silicium texturé à différentes puissances RF.

Selon un mode de réalisation de l'invention, le procédé de texturation en phase gazeuse de la surface d'un substrat de silicium comprend une étape a) de génération d'un plasma radiofréquence de SF₆/O₂ dans une chambre de réaction pendant une durée comprise entre 2 min et 30 min, conduisant à la formation d'un substrat de silicium ayant une surface texturée présentant des structures pyramidales. Le rapport SF₆/O₂ est compris entre 2 et 10, et la pression de SF₆/O₂ dans la chambre de réaction est comprise entre 50 mTorr et 150 mTorr.

La durée de l'étape a) est de préférence comprise entre 2 min et 30 min.

Le substrat de silicium peut être monocristallin ou multicristallin, avec des tailles de grain de l'ordre du millimètre. Le substrat de silicium peut être un substrat du type c-Si (100), par exemple. Il présente une résistivité comprise entre 0,5 Ω.cm et 30 Ω.cm. Le substrat de silicium peut être dopé n ou p.

L'étape a) de génération d'un plasma radiofréquence de SF₆/O₂ est précédée d'une étape a') d'exposition de la surface du substrat à un plasma radiofréquence d'oxygène pendant une durée allant jusqu'à 8 min.

L'étape a') permet d'améliorer l'uniformité de la texture du substrat.

Les étapes a) et a') sont réalisées dans un même appareil de gravure ionique réactive classique apte à générer un plasma radiofréquence en présence de gaz. La fréquence de l'appareil de gravure ionique réactive est de 13,56 MHz.

Lors de l'étape a) la puissance du plasma radiofréquence est supérieure ou égale à 3000 mW/cm².

La pression de SF₆/O₂ dans la chambre de réaction est inférieure ou égale à 100 mTorr, de façon à produire un substrat de silicium ayant une surface texturée présentant des structures pyramidales de type inversé.

Lors de l'étape a') la puissance du plasma radiofréquence est comprise entre 25 W, correspondant à une densité de puissance de 500 mW/cm², et 200 W, correspondant à une densité de puissance de 4000 mW/cm². Le plasma généré durant ces étapes est un plasma basse température (inférieur ou égal à 200°C).

De manière préférée, lors de l'étape a'), le plasma radiofréquence d'oxygène est généré pendant une durée de 5 min, avec une puissance radiofréquence (RF) de 150 W, soit une densité de puissance de 3000 mW/cm².

Ensuite, lors de l'étape a), de manière préférée, le plasma radiofréquence de SF₆/O₂ est généré pendant une durée de 15 min, avec une pression de SF₆/O₂ de 100 mTorr, et un rapport SF₆/O₂ égal à 3, correspondant à un débit de SF₆ de 99 cm³/sec, et un débit d'O₂ de 33 cm³/sec. La puissance du plasma RF est de 150 W, soit une densité de puissance de 3000 mW/cm².

Dans ces conditions optimales, on obtient un substrat de silicium c-Si (100) avec une surface texturée comprenant une multitude de pyramides inversées ayant une répartition de tailles comprises entre 200 nm et 3 µm, comme illustré sur les figures 2 à 4.

L'addition d'un gaz d'oxygène à un gaz de SF₆ joue un rôle important sur le plasma.

A la surface du substrat, deux effets opposés ont lieu dans le plasma SF₆/O₂: un processus de gravure dû aux radicaux de fluor qui sont très efficaces pour graver le silicium, et un processus de redéposition dû aux radicaux résiduels de SiOₓF_{y}, qui produisent un effet de masquage. Ces micro-masques augmentent la texturation de la surface du substrat c-Si.

Le rapport SF₆/O₂ détermine la densité des micro-masques, et un rapport égal à 3 améliore la densité des structures produites sur les plaquettes de silicium. D'autre part, la puissance du plasma RF détermine la forme des structures produites. En variant la puissance RF et en utilisant un rapport optimisé de gaz (SF₆/O₂ = 3), il est possible de produire les structures très différentes (pyramides normales ou inversées).

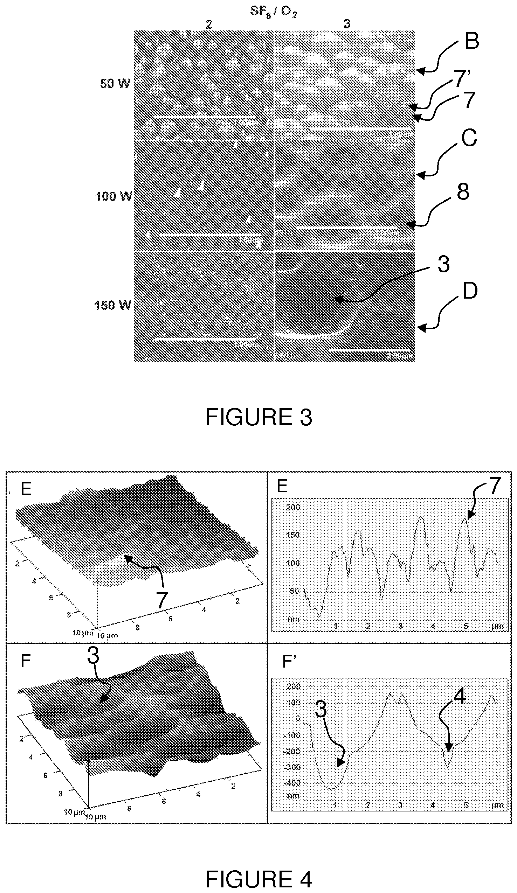

La figure 3 représente des photographies de substrats de silicium texturé obtenues avec un microscope électronique à balayage (MEB), pour des puissances RF de 50 W, 100 W et 150 W, et des rapports SF₆/O₂ de 2 et 3, et une pression du mélange SF₆/O₂ de 100 mTorr.

Cette figure 3 montre qu'une meilleure texturation est obtenue avec un rapport SF₆/O₂ égale à 3 et une puissance RF de 150 W.

La figure 2 représente schématiquement quatre coupes de substrat de silicium texturé obtenu avec des puissances RF différentes dont un substrat A obtenu à 25 W, un substrat B obtenu à 50 W, un substrat C obtenu à 100 W et un substrat D obtenu à 150 W. Le rapport SF₆/O₂ est égal à 3.

Pour une puissance de plasma RF de 25 W (substrat A), il est possible d'observer une densité de petits points texturés 6 ayant des tailles variant dans la gamme comprise entre 50 et 100 nm.

Une augmentation de la puissance RF à 50 W (substrat B) conduit à une densité de pyramides normales 7 plus élevée, avec des structures ayant des tailles variant dans la gamme comprise entre 200 et 500 nm.

Une augmentation de la puissance RF à 100 W mène à un changement spectaculaire de la texture extérieure (substrat C). Les pyramides sont remplacées par des structures en forme de cratères 8, avec une répartition de tailles comprises entre 200 nm et 800 nm.

Enfin à 150 W (substrat D), une grande densité de pyramide inversée 3 est générée avec un éventail de tailles compris entre 200 nm et 3 µm. De petites pyramides 4 sont superposées au-dessus de pyramides plus grandes 3.

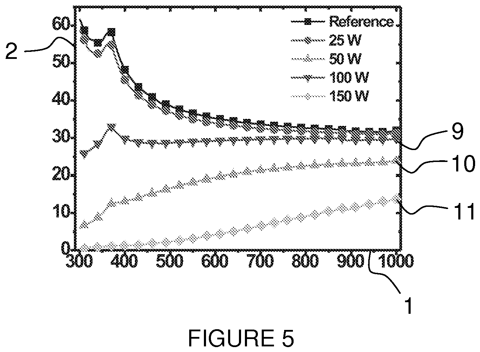

La figure 5 montre des courbes de réflectivité pour un substrat c-Si texturé, dans la gamme de longueurs d'onde de 300 à 1000 nm.

Les abscisses 1 représentent les longueurs d'ondes en nm, et les ordonnées 2 représentent la réflectivité en %.

Pour le substrat B de la figure 2 (puissance RF de 50 W), la courbe de réflectivité 10 de la figure 5 montre que la réflectivité moyenne est de 18 %.

Pour le substrat C de la figure 2 présentant des structures en forme de cratères 8 (puissance RF de 100 W), la courbe de réflectivité 9 montre que la réflectivité est de 29 %.

Une réduction de réflectivité plus intéressante a été obtenue avec le substrat D présentant des pyramides inversées 3, avec une réflectivité moyenne de 6 % (courbe de réflectivité 11).

Le changement de forme des pyramides normales aux pyramides inversées est également observé par AFM (« Atomic Force Spectroscopy »).

La figure 4 représente des images E et F et des profiles E' et F' de substrats de silicium texturé réalisées par AFM.

L'image E est une vue tridimensionnelle des pyramides normales 7, alors que l'image E' montre le profil de ces structures. Les pyramides normales 7 ont une largeur comprise entre 400 et 600 nm, et une hauteur comprise entre 100 et 150 nm.

L'image F montre une image tridimensionnelle des pyramides inversées 3, alors que l'image F' montre le profil de certaines de ces structures.

Les structures sont composées de grandes pyramides inversées 3 et de petites pyramides inversées 4 formées à l'intérieur d'une grande pyramide 3. La largeur des grandes pyramides inversées 3 est d'environ 3 µm. Les petites pyramides 4 ont une largeur comprise entre 200 nm et 1 µm. La profondeur de ces structures est comprise entre 300 et 500 nm.

Les figures 2 et 3, permettent d'expliquer l'évolution de structure des pyramides en fonction de la puissance RF.

A basse puissance RF (P = 25 W), il y a une formation de petits points blancs 6 sur la surface du substrat de silicium. Ces petits points blancs 6 sont protégés contre la gravure plasma par des micro-masques composés de radicaux de SiOₓF_{y}, qui sont des résidus de la gravure par plasma SF₆/O₂. Cependant le plasma n'est pas assez fort pour produire une surface plus texturée.

Lorsque la puissance RF est plus importante (P = 50 W), les micro-masques de SiOₓF_{y} protègent toujours le silicium placé en dessous (figure 2 substrat B). Au dessus de chaque pyramide 7, on peut observer un petit point blanc 7'.

A une puissance RF plus élevée, les pyramides sont complètement ablatées, ayant pour résultat une surface de substrat de silicium presque plate. Cependant quand la puissance RF est d'environ 100 W, la surface ne reste pas longtemps plate, puisqu'elle commence à être encore texturée, ce qui a pour conséquence l'apparition de cratères 8 à la surface du substrat de silicium.

Enfin, lorsque la puissance RF atteint 150 W, les structures en forme de cratères deviennent plus profondes et plus larges, semblables à des pyramides inversées 3. On obtient des structures de différentes tailles.

La puissance du plasma radiofréquence est de préférence fixe pendant les étapes a) et a').

Selon un mode de réalisation possible, pendant les étapes a) et/ou a'), la puissance du plasma radiofréquence est augmentée progressivement.

Le procédé de l'invention peut être mis en oeuvre dans un appareillage comprenant différentes chambres dont une chambre de gravure ionique dans laquelle est réalisée la texturation du substrat de silicium en phase gazeuse selon l'invention, et au moins une autre chambre de dépôt chimique en phase vapeur assisté par plasma (PECVD) dans laquelle est réalisée une ou plusieurs étapes de dépôt de silicium en vue d'obtenir une cellule solaire.

L'utilisation d'un appareillage unique permet d'éviter la contamination du substrat lors de son transfert entre les différentes chambres de réaction. On obtient un gain de temps et une réduction des coûts de fabrication.

La surface des substrats texturés selon le procédé de l'invention subie ensuite d'autres traitements comme des nettoyages de surface et de passivation.

Le procédé de l'invention peut être indépendamment appliqué sur une ou les deux faces opposées du substrat de silicium.

Un dépôt de silicium dopé en phase gazeuse peut être réalisé sur chacune de ces faces pour obtenir une hétérojonction de cellule solaire.

## Revendications

1. Procédé de texturation de la surface d'un substrat de silicium en phase gazeuse, comprenant au moins une étape a) d'exposition de ladite surface à un plasma radiofréquence de SF₆/O₂ dans une chambre de réaction d'un appareil de gravure ionique réactive pendant une durée comprise entre 2 min et 30 min, pour produire un substrat de silicium ayant une surface texturée présentant des structures pyramidales, le rapport de débit SF₆/O₂ étant compris entre 2 et 10,
**caractérisé en ce que** :
lors de l'étape a), la densité de puissance générée avec le plasma radiofréquence est supérieure ou égale à 3000 mW/cm², et la pression de SF₆/O₂ dans la chambre de réaction est inférieure ou égale à 100 mTorr, de façon à produire un substrat de silicium ayant une surface texturée présentant des structures pyramidales de type inversé, les structures pyramidales inversées présentant une largeur comprise entre 200 nm et 3 µm, et une profondeur comprise entre 200 nm et 1 µm, et **en ce qu'**il comprend, avant l'étape a), une étape a') d'exposition de ladite surface à un plasma radiofréquence d'oxygène pendant une durée allant jusqu'à 8 min, le plasma généré durant ces étapes a) et a') étant un plasma ayant une température inférieure ou égale à 200°C.

2. Procédé de texturation de la surface d'un substrat de silicium selon la revendication 1, **caractérisé en ce que** la durée de l'étape a') est de 5 min.

3. Procédé de texturation de la surface d'un substrat de silicium selon l'une quelconque des revendications 1 à 2, **caractérisé en ce que**, lors de l'étape a'), la densité de puissance générée avec le plasma radiofréquence est comprise entre 500 mW/cm² et 4000 mW/cm², la pression d'oxygène dans la chambre de réaction étant comprise entre 50 mTorr et 150 mTorr.

4. Procédé de texturation de la surface d'un substrat de silicium selon l'une quelconque des revendications 1 à 3, **caractérisé en ce que** la densité de puissance générée avec le plasma radiofréquence est égale à 3000 mW/cm².

5. Procédé de texturation de la surface d'un substrat de silicium selon l'une quelconque des revendications 1 à 4, **caractérisé en ce que**, lors de l'étape a), la pression de SF₆/O₂ dans la chambre de réaction est de 100 mTorr, le rapport de débit SF₆/O₂ est de 3 et la durée d'exposition au plasma est de 15 min.

6. Procédé de texturation de la surface d'un substrat de silicium selon l'une quelconque des revendications 1 à 5, **caractérisé en ce que** pendant les étapes a) et/ou a'), la puissance du plasma radiofréquence est augmentée progressivement.

7. Procédé de texturation de la surface d'un substrat de silicium selon l'une quelconque des revendications 1 à 6, **caractérisé en ce que** les étapes a) et a') sont réalisées dans un appareil de gravure ionique réactive.

8. Substrat de silicium texturé pour cellule solaire obtenu selon le procédé défini dans l'une des revendications 1 à 7, présentant au moins une surface texturée avec des structures pyramidales du type inversé et une résistivité comprise entre 0,5 Ω.cm et 30 Ω.cm, **caractérisé en ce que** les structures pyramidales inversées présentent une largeur comprise entre 200 nm et 3 µm, et une profondeur comprise entre 200 nm et 1 µm.

9. Substrat de silicium texturé pour cellule solaire selon la revendication 8, **caractérisé en ce que** la surface texturée du substrat de silicium présente des structures en forme de pyramide inversée de grandes tailles (3), et des structures en forme de pyramide inversée de petites tailles (4), la largeur des structures en forme de pyramide inversée de grandes tailles (3) étant comprise entre 1 µm et 5 µm, et la largeur des structures en forme de pyramide inversée de petites tailles (4) étant comprise entre 200 nm et 1 µm.

## Patentansprüche

1. Verfahren zur Texturierung der Oberfläche eines Siliziumsubstrats in der Gasphase, mit wenigstens einem Schritt a) des während einer Dauer zwischen 2 Minuten und 30 Minuten in einer Reaktionskammer eines Geräts für reaktives Ionenätzen einem Hochfrequenzplasma von SF₆/O₂ Aussetzens der Oberfläche, um ein Siliziumsubstrat mit einer texturierten Oberfläche zu schaffen, die pyramidenartige Strukturen aufweist, wobei das Durchflußverhältnis SF₆/O₂ zwischen 2 und 10 beträgt,
**dadurch gekennzeichnet, daß**
beim Schritt a) die mit dem Hochfrequenzplasma erzeugte Leistungsdichte größer als oder gleich 3000 mW/cm² und der Druck des SF₆/O₂ in der Reaktionskammer kleiner als oder gleich 100 mTorr ist, um ein Siliziumsubstrat mit einer texturierten Oberfläche zu erzeugen, die pyramidenartige Strukturen vom inversen Typ aufweist, wobei die inversen pyramidenartigen Strukturen eine Breite zwischen 200 nm und 3 µm und eine Tiefe zwischen 200 nm und 1 µm aufweisen, und dadurch, daß es vor dem Schritt a) einen Schritt a') des während einer bis zu 8 Minuten langen Dauer einem Hochfrequenzplasma von Sauerstoff Aussetzens der Oberfläche aufweist, wobei das während dieser Schritte a) und a') erzeugte Plasma ein Plasma mit einer Temperatur von weniger als oder gleich 200 °C ist.

2. Verfahren zur Texturierung der Oberfläche eines Siliziumsubstrats gemäß Anspruch 1, **dadurch gekennzeichnet, daß** die Dauer des Schritts a') 5 Minuten beträgt.

3. Verfahren zur Texturierung der Oberfläche eines Siliziumsubstrats gemäß einem der Ansprüche 1 bis 2, **dadurch gekennzeichnet, daß** beim Schritt a') die mit dem Hochfrequenzplasma erzeugte Leistungsdichte zwischen 500 mW/cm² und 4000 mW/cm2 und der Sauerstoffdruck in der Reaktionskammer zwischen 50 mTorr und 150 mTorr betragt.

4. Verfahren zur Texturierung der Oberfläche eines Siliziumsubstrats gemäß einem der Ansprüche 1 bis 3, **dadurch gekennzeichnet, daß** die mit dem Hochfrequenzplasma erzeugte Leistungsdichte 3000 mW/cm² beträgt.

5. Verfahren zur Texturierung der Oberfläche eines Siliziumsubstrats gemäß einem der Ansprüche 1 bis 4, **dadurch gekennzeichnet, daß** beim Schritt a) der SF₆/O₂-Druck in der Reaktionskammer 100 mTorr beträgt, das Durchflußverhältnis SF₆/O₂ 3 beträgt und die Dauer des dem Plasma Aussetzens 15 Minuten beträgt.

6. Verfahren zur Texturierung der Oberfläche eines Siliziumsubstrats gemäß einem der Ansprüche 1 bis 5, **dadurch gekennzeichnet, daß** bei den Schritten a) und/oder a') die Leistung des Hochfrequenzplasmas progressiv erhöht wird.

7. Verfahren zur Texturierung der Oberfläche eines Siliziumsubstrats gemäß einem der Ansprüche 1 bis 6, **dadurch gekennzeichnet, daß** die Schritte a) und a') in einem Gerät für reaktives Ionenätzen durchgeführt werden.

8. Texturiertes Siliziumsubstrat für eine Solarzelle, das nach dem in einem der Ansprüche 1 bis 7 definierten Verfahren erhalten worden ist und das wenigstens eine texturierte Oberfläche mit pyramidenartigen Strukturen vom inversen Typ und einen spezifischen Widerstand zwischen 0,5 Ωcm und 30 Ωcm aufweist, **dadurch gekennzeichnet, daß** die inversen pyramidenartigen Strukturen eine Breite zwischen 200 nm und 3 µm und eine Tiefe zwischen 200 nm und 1 µm aufweisen.

9. Texturiertes Siliziumsubstrat für eine Solarzelle gemäß Anspruch 8, **dadurch gekennzeichnet, daß** die texturierte Oberfläche des Siliziumsubstrats Strukturen in Form von inversen Pyramiden großer Größe (3) und Strukturen in Form von inversen Pyramiden kleiner Größe (4) aufweist, wobei die Breite der Strukturen in Form von inversen Pyramiden großer Größen (3) zwischen 1 µm und 5 µm und die Breite der Strukturen in Form von inversen Pyramiden kleiner Größen (4) zwischen 200 nm und 1 µm beträgt.

## Claims

1. A method of texturing the surface of a silicon substrate in the gas phase, comprising at least one step a) for exposing said surface to an SF₆/O₂ radiofrequency plasma in a reaction chamber of a reactive ion etching apparatus for a period comprised between 2 minutes and 30 minutes, to produce a silicon substrate having a textured surface exhibiting pyramidal structures, the SF₆/O₂ flow rate ratio being comprised between 2 and 10;
**characterized in that**:
during step a), the power density generated with the radiofrequency plasma is greater than or equal to 3000 mW/cm², and the pressure of SF₆/O₂ in the reaction chamber is less than or equal to 100 mTorr, so as to produce a silicon substrate with a textured surface having inverted type pyramidal structures, the inverted pyramidal structures having a width comprised between 200 nm and 3 µm, and a depth comprised between 200 nm and 1 µm, and wherein, before step a), a step a') of exposing said surface to an oxygen radiofrequency plasma for a period of up to 8 minutes, the plasma generated during these steps a) and a') being a plasma with a temperature less than or equal to 200°C.

2. A method of texturing the surface of a silicon substrate according to claim 1, **characterized in that** the duration of step a') is 5 minutes.

3. A method of texturing the surface of a silicon substrate according to any one of claims 1 to 2, **characterized in that**, during step a'), the power density generated with the radiofrequency plasma is comprised between 500 mW/cm² and 4000 mW/cm², the pressure of oxygen in the reaction chamber being comprised between 50 mTorr and 150 mTorr.

4. A method of texturing the surface of a silicon substrate according to any one of claims 1 to 3, **characterized in that** the power density generated with the radiofrequency plasma is equal to 3000 mW/cm².

5. A method of texturing the surface of a silicon substrate according to any one of claims 1 to 4, **characterized in that**, during step a), the pressure of SF₆/O₂ in the reaction chamber is 100 mTorr, the SF₆/O₂ flow rate ratio is 3, and the plasma exposure period is 15 minutes.

6. A method of texturing the surface of a silicon substrate according to any one of claims 1 to 5, **characterized in that** during steps a) and/or a'), the power of the radiofrequency plasma is progressively increased.

7. A method of texturing the surface of a silicon substrate according to any one of claims 1 to 6, **characterized in that** steps a) and a') are carried out in a reactive ion etching apparatus.

8. A textured silicon substrate for a solar cell obtained by the method defined according to any one of claims 1 to 7, having at least one textured surface with inverted type pyramidal structures and a resistivity comprised between 0.5 Ω.cm and 30 Ω.cm, **characterized in that** the inverted pyramidal structures have a width comprised between 200 nm and 3 µm, and a depth comprised between 200 nm and 1 µm.

9. The textured silicon substrate for a solar cell according to claim 8, **characterized in that** the textured surface of the silicon substrate has structures in the form of large inverted pyramids (3) and structures in the form of small inverted pyramids (4), the width of the structures in the form of large inverted pyramids (3) being comprised between 1 µm and 5 µm and the width of the structures in the form of small inverted pyramids (4) being comprised between 200 nm and 1 µm.
